# EUROPÄISCHE PATENTANMELDUNG

(11) **EP 3 787 042 A1**
(43) Veröffentlichungstag der Anmeldung: **03.03.2021**
(21) Anmeldenummer: 20000292.1
(22) Anmeldetag: 17.08.2020
(51) Int. Cl.: H01L 31/0687, H01L 31/0224

(54) **MEHRFACHSOLARZELLE MIT RÜCKSEITENKONTAKTIERTER VORDERSEITE**

(30) Priorität: 29.08.2019 DE 102019006091
(71) Anmelder: AZUR SPACE Solar Power GmbH, 74072 Heilbronn (DE)
(72) Erfinder: Köstler, Wolfgang, 74074 Heilbronn (DE)
(74) Vertreter: Koch Müller Patentanwaltsgesellschaft mbH

(57) **Zusammenfassung**

Stapelförmige Mehrfachsolarzelle mit rückseitenkontaktierter Vorderseite, aufweisend ein eine Rückseite der Mehrfachsolarzelle ausbildendes Germanium-Substrat, eine Germanium-Teilzelle und mindestens zwei III-V-Teilzellen in der genannten Reihenfolge aufeinander folgend sowie mindestens eine von der Vorderseite der Mehrfachsolarzelle durch die Teilzellen bis zu der Rückseite reichende Durchgangskontaktöffnung und einen durch die Durchgangskontaktöffnung geführten metallischen Anschlusskontakt, wobei die Durchgangskontaktöffnung eine zusammenhängende Seitenfläche und in einem Querschnitt einen ovalen Umfang aufweist, wobei ein Durchmesser der Durchgangskontaktöffnung von der Vorderseite zu der Rückseite der Mehrfachsolarzelle hin stufenförmig abnimmt, wobei eine Vorderseite der Germanium-Teilzelle eine umlaufend in die Durchgangskontaktöffnung hinein ragende erste Stufe mit einer ersten Auftrittstiefe ausbildet, wobei eine umlaufend in die Durchgangskontaktöffnung hinein ragende zweite Stufe mit einer zweiten Auftrittstiefe von einem unterhalb eines pn-Übergangs der Germanium-Teilzelle befindlichen Bereich der Germanium-Teilzelle ausgebildet wird.

## Beschreibung

Die Erfindung betrifft eine stapelförmige Mehrfachsolarzelle mit rückseitenkontaktierter Vorderseite.

Um die Abschattung der Vorderseite einer Solarzelle zu reduzieren, ist es möglich, sowohl die positive als auch die negative externe Kontaktfläche auf der Rückseite anzuordnen. Bei sogenannte metal wrap through (MWT) - Solarzellen wird die Solarzellenvorderseite beispielsweise durch eine Durchgangskontaktöffnung von der Rückseite aus kontaktiert.

Es sind unterschiedliche Verfahren zur Herstellung eines Loch bzw. einer Durchgangskontaktöffnung durch eine Solarzelle bekannt, welche in entsprechend unterschiedlichen Durchgangskontaktöffnungen resultieren.

Aus "Die Metal Wrap Through Solarzelle - Entwicklung und Charakterisierung", F. Clement, Dissertation, Februar 2009 ist Herstellungsverfahren für eine MWT-einfach-Solarzelle aus multikristallinem Silizium bekannt, wobei die Durchgangskontaktöffnungen mittels eines UV-Lasers oder eines IR-Lasers in einer mc Si-Substratschicht erzeugt werden.

Erst anschließend wird mittels Phosphordiffusion entlang der Oberseite, der Seitenflächen der Durchgangskontaktöffnung und der Unterseite der Solarzelle eine Emitterschicht erzeugt. Die Durchgangskontaktöffnung wird mit mittels Siebdrucks mit einer leitfähigen Via-Paste, z.B. einer Silberpaste, gefüllt.

Mit dem Laser kann eine sehr glatte Seitenfläche im Bereich des Durchgangslochs erreicht werden, außerdem treten bei einem Laser-Ablations-Prozess keine Hinterschneidungen auf. Das Erzeugen eines Lochs durch einen bestehenden pn-Übergang mittels Laser-Ablation würde allerdings zu Kurzschlüssen führen.

Aus "III-V multi-junction metal-wrap-through (MWT) concentrator solar cells", E. Oliva et al., Proceedings, 32nd European PV Solar Energy Conference and Exhibition, München, 2016, pp. 1367-1371, ist eine invertiert gewachsene GaInP/AlGaAs Solarzellenstruktur mit Durchgangskontaktöffnungen bekannt, wobei die Solarzellenstruktur mit den pn-Übergängen epitaktisch gewachsen und ersten anschließend die Durchgangskontaktöffnungen mittels Trockenätzen erzeugt wird. Eine Seitenfläche der Durchgangsöffnung wird anschließend mit einer Isolationsschicht beschichtet und die Durchgangsöffnung wird anschließend mit galvanisiertem Kupfer gefüllt.

Aus der US 9,680,035 B1 ist ein Solarzellenstapel aus mehreren III-V-Teilzellen auf einem GaAs-Substrat mit rückseitenkontaktierter Vorderseite bekannt, wobei ein von der Oberseite der Solarzelle durch die Teilzellen bis in eine noch nicht gedünnte Substratschicht hinein reichendes Loch mittels eines nasschemischen Ätzprozesses erzeugt wird.

Der Ätzprozess basiert darauf, dass sich die Ätzraten zumindest für die verwendeten unterschiedlichen III-V-Materialien des Solarzellenstapels nicht Wesentlich unterschieden. Das Loch wird erst durch Dünnen der Substratschicht nach unten geöffnet. Eine Passivierung und Metallisierung der Vorderseite und des Lochs wird vor dem Dünnen der Substratschicht durchgeführt. Das nasschemische Ätzen hat im Vergleich zu entsprechenden Trockenätzprozessen den Vorteil, dass die Seitenwände des Lochs eine glattere Oberfläche aufweisen und die Passivierungsschicht konform und ohne Fehlstellen abgeschieden werden kann.

Vor diesem Hintergrund besteht die Aufgabe der Erfindung darin, eine Vorrichtung anzugeben, die den Stand der Technik weiterbildet.

Die Aufgabe wird durch eine stapelförmige Mehrfachsolarzelle mit den Merkmalen des Patentanspruchs 1 gelöst. Vorteilhafte Ausgestaltungen der Erfindung sind Gegenstand von Unteransprüchen.

Gemäß dem Gegenstand der Erfindung wird eine stapelförmige Mehrfachsolarzelle mit rückseitenkontaktierter Vorderseite bereitgestellt.

Die Mehrfachsolarzelle weist ein eine Rückseite der Mehrfachsolarzelle ausbildendes Germanium-Substrat mit einer Germanium-Teilzelle und mindestens zwei III-V-Teilzellen in der genannten Reihenfolge aufeinander folgend auf.

Ferner weist die Mehrfachzelle mindestens eine von der Vorderseite der Mehrfachsolarzelle durch die Teilzellen bis zu der Rückseite reichende Durchgangskontaktöffnung und einen durch die Durchgangskontaktöffnung geführten metallischen Anschlusskontakt auf.

Die Durchgangskontaktöffnung weist eine zusammenhängende Seitenfläche und in einem Querschnitt einen ovalen Umfang auf.

Ein Durchmesser der Durchgangskontaktöffnung nimmt von der Vorderseite zu der Rückseite der Mehrfachsolarzelle hin stufenförmig ab, wobei in einer Projektion ausgehend von der Vorderseite in Richtung der Germanium-Teilzelle eine in die Durchgangskontaktöffnung hinein ragende umlaufende erste Stufe mit einer ersten Auftrittstiefe ausbildet ist.

Des Weiteren ist eine in die Durchgangskontaktöffnung hinein ragende umlaufende zweite Stufe mit einer zweiten Auftrittstiefe von einem unterhalb eines pn-Übergangs der Germanium-Teilzelle befindlichen Bereich ausgebildet.

Gemäß einer Weiterbildung weist die Mehrfachsolarzelle genau zwei Durchgangskontaktöffnungen auf.

Es versteht sich, dass die einzelnen Teilzellen der Mehrfachsolarzelle jeweils einen pn-Übergang aufweisen und die auf das Substrat folgenden Schichten epitaktisch aufeinander erzeugt und/oder mittels Wafer-Bond miteinander verbunden sind.

Außerdem versteht es sich, dass eine Germanium-Teilzelle Germanium aufweist oder aus Germanium besteht, wobei auch eine aus Germanium bestehende Schicht gegebenenfalls zusätzlich zu dem Germanium noch weitere Stoffe, insbesondere Dotierstoffe, aber auch Verunreinigungen enthält. Entsprechendes gilt auch für die III-V-Teilzellen, welche ein oder mehrere Materialien der III. sowie der V. Hauptgruppe aufweisen oder aus solchen Materialien bzw. einer solchen Materialkombination bestehen.

Der im Bereich der Oberseite der Mehrfachsolarzelle größere Durchmesser der Durchgangskontaktöffnung und der sich nach unten stufenförmig verjüngende Verlauf des Durchgangskontaktlochs weist keine Unterätzungen auf, wodurch sichergestellt wird, dass eine Beschichtung, z.B. eine Isolationsschicht, auf einfache Weise, beispielsweise mittels Gasphasenabscheidung, zuverlässig und ohne Fehlstellen aufgebracht werden kann.

Darüber hinaus ist die stufige Durchgangsöffnung auf einfache Weise herstellbar, z.B. mittels eines zweistufigen Ätzprozesses, welche Unterätzungsfrei alle pn-Übergänge entfernt, und einem anschließenden Laser-Ablationsprozess, welche ein schnelles und einfaches Durchtrennen der restlichen Ge-Teilezelle und des Ge-Substrats ermöglicht, selbst wenn das Ge-Substrat noch nicht oder nicht besonders gedünnt wurde.

Vorteil der erfindungsgemäßen Mehrfachsolarzelle ist eine besonders hohe Zuverlässigkeit und Effizienz bei verhältnismäßig geringen Herstellungskosten.

Gemäß einer ersten Ausführungsform ist die Seitenfläche der Durchgangskontaktöffnung mit einer dielektrischen Isolationsschicht beschichtet.

Vorzugsweise ist der metallische Anschlusskontakt als eine auf der dielektrischen Isolationsschicht sich von der Vorderseite bis zu der Rückseite der Mehrfachsolarzelle erstreckende metallische Kontaktschicht ausgebildet.

In einer anderen Ausführungsform weisen die III-V-Tellzellen eine gemeinsame Schichtdicke von 5 -15 µm oder von 6 - 8 µm auf.

Gemäß einer anderen Weiterbildung weist die Durchgangskontaktöffnung an der Vorderseite der Mehrfachsolarzelle einen Durchmesser von mindestens 300 µm oder mindestens 400 µm oder mindestens 450 µm auf, wobei der Durchmesser nicht größer als 1 mm ist.

Gemäß einer weiteren Weiterbildung weist die Seitenfläche der Durchgangskontaktöffnung zwischen den Stufen und/oder oberhalb der ersten Stufe und/oder unterhalb der zweiten Stufe jeweils zu einer Längsachse der Durchgangskontaktöffnung einen Winkel von höchstens 10° oder höchstens 2° oder höchstens 1° oder höchstens 0,1° auf.

In einer anderen Ausführungsform beträgt die erste Auftrittstiefe der ersten Stufe mindestens 100 µm oder mindestens 200 µm.

In einer weiteren Ausführungsform beträgt die zweite Auftrittstiefe der zweiten Stufe mindestens 5 µm oder mindestens 10 µm.

In einer anderen Weiterbildung weist die Germanium-Teilzelle zusammen mit dem Germanium-Substrat eine Schichtdicke von 80 - 300 µm oder von 140 - 160 µm oder von 80 - 120 µm auf.

Gemäß einer weiteren Ausführungsform beträgt eine Steighöhe von der zweiten Stufe zu der ersten Stufe 1 - 4 µm oder 1 - 3 µm oder 2 µm.

Gemäß einer anderen Ausführungsform umfasst die Mehrfachsolarzelle eine die Vorderseite ausbildende III-V-Deckschicht, z.B. aus InGaP, mit einer Dicke von 150 - 500 nm und einer Bandlücke von mindestens 1,86 eV umfasst.

Die Erfindung wird nachfolgend unter Bezugnahme auf die Zeichnungen näher erläutert. Hierbei werden gleichartige Teile mit Identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigt:
- Figur 1: einen Querschnitt einer erste erfindungsgemäße Ausführungsform einer Durchgangskontaktöffnung einer stapelförmigen Mehrfachsolarzelle mit rückseitenkontaktierter Vorderseite,
- Figur 2: eine Aufsicht auf eine erfindungsgemäße Ausführungsform der Mehrfachsolarzelle,
- Figur 3: eine Rückseite einer erfindungsgemäßen Ausführungsform der Mehrfachsolarzelle,
- Figur 4: einen Querschnitt einer weiteren erfindungsgemäßen Ausführungsform der Durchgangskontaktöffnung.

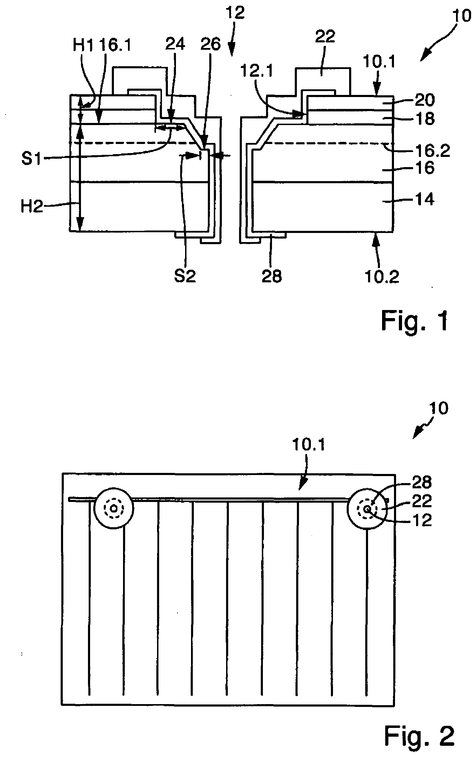

Die Abbildung der Figur 1 zeigt einen Ausschnitt einer stapelförmigen Mehrfachsolarzelle 10 mit rückseitenkontaktierter Vorderseite in einem Querschnitt. Die Mehrfachsolarzelle weist eine Oberseite 10.1 und eine Unterseite 10.2 sowie eine von der Oberseite 10.1 bis zu der Unterseite 10.2 reichende Durchgangsöffnung 12 auf.

Die Unterseite 10.2 wird durch ein Germanium-Substrat 14 ausgebildet. Auf dem Germanium-Substrat folgen eine Germanium-Teilzelle 16, eine erste III-V-Teilzelle 18 und eine die Oberseite 10.2 ausbildende zweite III-V-Teilzelle 20 in der genannten Reihenfolge.

Die beiden III-V-Teilzellen 18 und 20 weisen zusammen eine erste Schichtdicke H1 auf. Das Germanium-Substrat 13 weist zusammen mit der Germanium-Teilzelle eine zweite Schichtdicke H2 auf.

Die Durchgangsöffnung 12 weist eine Seitenfläche 12.1 auf, wobei die Seitenfläche 12.1 wie eine Mantelfläche eines Zylinders zusammenhängend ausgebildet ist und in einem Querschnitt eine ovale Form, z.B. kreisförmig oder elliptisch, aufweist.

Die Durchgangsöffnung 12 weist außerdem zwei Stufen 24 und 26 auf. Die erste Stufe 24 wird von einer Vorderseite 16.1 der Germanium-Teilzelle 16 ausgebildet, wobei die Oberseite 16.1 eine umlaufende Auftrittsfläche mit einer in radialer Richtung konstanten Auftrittstiefe S1 ausbildet.

Die zweite Stufe 26 befindet sich in einem Bereich der Germanium-Teilzelle 16 unterhalb eines pn-Übergangs 16.2 der Germanium-Teilzelle 16 und weist eine umlaufende Auftrittsfläche mit einer Auftrittstiefe S2 auf.

Die Seitenfläche 12.1 der Durchgangskontaktöffnung 12 sowie ein sich an die Durchgangsöffnung 12 anschließender Bereich der Oberseite 10.1 sowie der Unterseite 10.2 sind mit einer dielektrischen Isolationsschicht 28 bedeckt.

Ein metallischer Anschlusskontakt 22 ist als metallische Kontaktschicht ausgebildet, welche sich von einem sich an die dielektrische Isolationsschicht 28 anschließenden Bereich der Oberseite 10.1 des Mehrfachsolarzelle 10 auf der dielektrische Isolationsschicht 28 durch die Durchgangskontaktöffnung bis zu dem von der dielektrischen Isolationsschicht 28 bedeckten Bereich der Unterseite 10.2 der Mehrfachsolarzelle.

Die metallische Kontaktschicht 22 ist sowohl mit der Oberseite 10.1 der Mehrfachsolarzelle 10 als auch mit der dielektrischen Isolationsschicht 28 stoffschlüssig verbunden.

In der Abbildung der Figur 2 ist eine weitere Ausführungsform der Mehrfachsolarzelle in einer Aufsicht auf die Vorderseite 10.1 dargestellt. Im Folgenden werden nur die Unterschiede zu der Abbildung der Figur 1 erläutert.

Die Mehrfachsolarzelle 10 weist genau zwei Durchgangskontaktöffnungen 12 auf, wobei die beiden Durchgangskontaktöffnungen 12 jeweils an einem Ende einer Sammelschiene angeordnet sind und die metallische Kontaktschichten 22 jeweils mit der Kontaktschiene elektrisch leitfähig verbunden ist.

In regelmäßigen Abständen erstrecken sich Kontaktfinger senkrecht zu der Sammelschiene über die Oberseite 10.1 der Mehrfachsolarzelle, wobei jeder Kontaktfinger elektrisch Leitfähig mit der Sammelschiene und/oder einer der Kontaktschichten 22 verbunden ist.

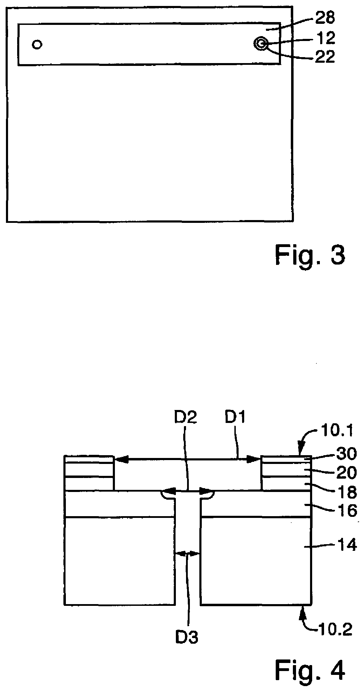

In der Abbildung der Figur 3 ist eine weitere Ausführungsform der Mehrfachsolarzelle in einer Aufsicht auf die Rückseite 10.2 dargestellt. Im Folgenden werden nur die Unterschiede zu der Abbildung der Figur 1 erläutert.

Die Mehrfachsolarzelle 10 weist genau zwei Durchgangskontaktöffnungen 12 auf. Die beiden Durchgangskontaktöffnungen sind von einer zusammenhängenden dielektrischen Isolationsschicht 28 umgeben.

In der Abbildung der Figur 4 ist ein Querschnitt im Bereich der Durchgangsöffnung einer weiteren Ausführungsform der Mehrfachsolarzelle dargestellt, wobei im Folgenden nur die Unterschiede zu der Abbildung der Figur 1 erläutert werden.

Die dielektrische Schicht 28 sowie die metallische Kontaktschicht 22 sind der Übersichtlichkeit halber nicht dargestellt.

Die Mehrfachsolarzelle weist auf der zweiten III-V-Teilzelle 20 eine III-V-Deckschicht 30, z.B. eine InGaP-Schicht, auf, welche die Oberseite 10.1 der Mehrfachsolarzelle 10ausbildet.

Die beispielsweise durch zwei Ätzprozesse und einen Laser-Ablations-Prozess erzeugte Durchgangsöffnung weist drei jeweils durch eine der Stufen S1 oder S2 getrennte Bereiche auf.

Der erste Bereich erstreckt sich von der Oberseite 10.1 der Mehrfachsolarzelle 10 bis zu der Oberseite 16.2 der Germanium-Tellzelle, wobei der erste Bereich einen konstanten oder nur geringfügig in Richtung der Germanium-Teilzelle abnehmenden Durchmesser D1 aufweist.

Der zweite Bereich erstreckt sich von der Oberseite 16.1 der Germanium-Teilzelle 16 in die Germanium-Teilzelle 16 hinein und weist einen konstanten oder in Richtung des Germanium-Substrats 14 abnehmenden Durchmesser D2 auf.

Der dritte Bereich erstreckt sich von der zweiten Stufe S2 bis zu der Unterseite 10.2 der Mehrfachsolarzelle und weist einen konstanten oder geringfügig in Richtung der Unterseite 10.2 abnehmenden Durchmesser D3 auf.

## Patentansprüche

1. Stapelförmige Mehrfachsolarzelle (10) mit rückseitenkontaktierter Vorderseite (10.1), aufweisend ein eine Rückseite (10.2) der Mehrfachsolarzelle (10) ausbildendes Germanium-Substrat (14), eine Germanium-Teilzelle (16) und mindestens zwei III-V-Teilzellen (18, 20) in der genannten Reihenfolge aufeinander folgend sowie mindestens eine von der Vorderseite (10.1) der Mehrfachsolarzelle (10) durch die Teilzellen (16, 18, 20) bis zu der Rückseite reichende Durchgangskontaktöffnung (12) und einen durch die Durchgangskontaktöffnung (12) geführten metallischen Anschlusskontakt (22),
- wobei die Durchgangskontaktöffnung (12) eine zusammenhängende Seitenfläche (12.1) und in einem Querschnitt einen ovalen Umfang aufweist,
- wobei ein Durchmesser (D) der Durchgangskontaktöffnung (12) von der Vorderseite (10.1) zu der Rückseite (10.2) der Mehrfachsolarzelle (10) hin stufenförmig abnimmt,
- wobei in einer Projektion ausgehend von der Vorderseite (16.1) in Richtung der Germanium-Tellzelle (16)
- eine in die Durchgangskontaktöffnung (12) hinein ragende umlaufende erste Stufe (24) mit einer ersten Auftrittstiefe (S1) ausbildet ist, und
- eine in die Durchgangskontaktöffnung (12) hinein ragende umlaufend zweite Stufe (26) mit einer zweiten Auftrittstiefe (S2) von einem unterhalb eines pn-Übergangs (16.2) der Germanium-Teilzelle (16) befindlichen Bereich der Germanium-Teilzelle (16) ausgebildet ist.

2. Stapelförmige Mehrfachsolarzelle (10) nach Anspruch 1, **dadurch gekennzeichnet, dass** die Seitenfläche (12.1) der Durchgangskontaktöffnung (12) mit einer dielektrischen Isolationsschicht (28) beschichtet sind und der metallische Anschlusskontakt (22) als eine sich von der Vorderseite (10.1) bis zu der Rückseite (10.2) der Mehrfachsolarzelle (10) erstreckende metallische Kontaktschicht auf der dielektrischen Isolationsschicht (28) und auf einem an die Isolationsschicht (28) angrenzenden Bereich der Oberseite (10.1) der Mehrfachsolarzelle ausgebildet ist.

3. Stapelförmige Mehrfachsolarzelle (10) nach Anspruch 1 oder 2, **dadurch gekennzeichnet, dass** die III-V-Teilzellen (18, 20) eine gemeinsame Schichtdicke (H1) von 5 -15 µm oder von 6 - 8 µm aufweisen.

4. Stapeiförmige Mehrfachsolarzelle (10) nach einem der vorstehenden Ansprüche, **dadurch gekennzeichnet, dass** die Durchgangskontaktöffnung (12) an der Vorderseite (10.1) der Mehrfachsolarzelle (10) einen Durchmesser (D1) von mindestens 300 µm oder mindestens 400 µm oder mindestens 450 µm aufweist, wobei der Durchmesser (D1) nicht größer als 1 mm ist.

5. Stapelförmige Mehrfachsolarzelle (10) nach einem der vorstehenden Ansprüche, **dadurch gekennzeichnet, dass** die Seitenfläche (12.1) der Durchgangskontaktöffnung (12) zwischen den Stufen (24, 26) und/oder oberhalb der ersten Stufe (24) und/oder unterhalb der zweiten Stufe (26) jeweils zu einer Längsachse der Durchgangskontaktöffnung (12) einen Winkel von höchstens 10° oder höchstens 2° oder höchstens 1° oder höchstens 0,1° aufweist.

6. Stapelförmige Mehrfachsolarzelle (10) nach einem der vorstehenden Ansprüche, **dadurch gekennzeichnet, dass** die Auftrittstiefe (S1) der ersten Stufe (24) mindestens 100 µm oder mindestens 200 µm beträgt.

7. Stapelförmige Mehrfachsolarzelle (10) nach einem der vorstehenden Ansprüche, **dadurch gekennzeichnet, dass** die Auftrittstiefe (S2) der zweiten Stufe (26) mindestens 5 µm oder mindestens 10 µm beträgt.

8. Stapelförmige Mehrfachsolarzelle (10) nach einem der vorstehenden Ansprüche, **dadurch gekennzeichnet, dass** die Germanium-Teilzelle (16) zusammen mit dem Germanium-Substrat (12) eine Schichtdicke (H2) von 80 - 300 µm oder von 140 - 160 µm oder von 80 - 120 µm aufweist.

9. Stapelförmige Mehrfachsolarzelle (10) nach einem der vorstehenden Ansprüche, das eine Steighöhe von der zweiten Stufe (26) zu der ersten Stufe (24) 1 - 4 µm oder 1 - 3 µm oder 2 µm beträgt.

10. Stapelförmige Mehrfachsolarzelle (10) nach einem der vorstehenden Ansprüche, **dadurch gekennzeichnet, dass** die Mehrfachsolarzelle (10) eine die Vorderseite (10.1) ausbildende III-V-Deckschicht (30) mit einer Dicke von 150 - 500 nm und einer Bandlücke von mindestens 1,86 eV umfasst.
